# EUROPEAN PATENT APPLICATION

(11) **EP 4 761 510 A1**
(43) Date of publication of application: **17.06.2026**
(21) Application number: 24219426.4
(22) Date of filing: 12.12.2024
(51) Int. Cl.: H10D 64/01, H10D 30/01, H10D 30/00, H10D 30/67, H10D 84/01, H10D 84/85, H10D 88/00

(54) **A METHOD FOR FORMING A SEMICONDUCTOR DEVICE**

(71) Applicant: Imec VZW, 3001 Leuven (BE)
(72) Inventor: PETERSEN BARBOSA LIMA, Lucas, 3050 Oud-Heverlee (BE); CHAN, Boon Teik, 3012 Wilsele (BE); MERTENS, Hans, 3000 Leuven (BE)
(74) Representative: AWA Sweden AB

(57) **Abstract**

The present invention provides a method for forming a semiconductor device (100), comprising:
providing a substrate (102) having a frontside (102a) and a backside (102b);
forming a fin (104) on the frontside (102a), the fin (104) comprising a fin base (105), the fin (104) extending across a gate zone (150) and across a source/drain zone (160);
forming gate spacers (125) in the gate zone (150), the gate spacers (125) comprising a second dielectric material (108b);
forming an interlayer dielectric layer (166) in the source/drain zone (160), the interlayer dielectric layer (166) comprising a third dielectric material (108c);
depositing a bottom dielectric layer (156), the bottom dielectric layer (156) comprising a fourth dielectric material (108d);
wherein the second dielectric material (108b), the third dielectric material (108c), and the fourth dielectric material (108d) comprise different materials;
removing the substrate (102), wherein a backside surface exposes the second dielectric material (108b), the third dielectric material (108c), and the fourth dielectric material (108d).

## Description

### TECHNICAL FIELD

The present disclosure relates to a method for forming a semiconductor device.

### BACKGROUND

Backside patterning in semiconductor processing refers to techniques used to form patterns on the backside of e.g. a wafer. The wafer may be a silicon wafer. The process of backside patterning may entail an alignment process. The alignment process in backside patterning is crucial for ensuring that the patterns on the backside of the wafer are aligned with those on the frontside of the wafer.

### SUMMARY

It is an objective of the present inventive concept to provide an improved method for backside patterning.

A further objective is to provide a method with improved etch selectivity.

A further objective is to provide a method for backside patterning having comparably less stringent alignment requirements.

Further and alternative objectives may be understood from the following.

According to a first aspect of the invention, there is provided a method for forming a semiconductor device, comprising:
providing a substrate having a frontside and a backside;
forming a fin on the frontside of the substrate, the fin comprising a fin base and at least one channel layer arranged on the fin base;
forming a shallow trench isolation, STI, the STI being arranged
adjacent to the fin base and extending along the fin base, the STI comprising a first dielectric material, the fin and the STI extending across a gate zone and across a source/drain zone;
forming a dummy gate on the STI in the gate zone, the dummy gate straddling the fin;
forming gate spacers in the gate zone, the gate spacers straddling the fin and extending along opposing sides of the dummy gate, and the gate spacers comprising a second dielectric material;
recessing the fin in the source/drain zone to form a source/drain recess exposing an end of the at least one channel layer and forming a source/drain region on the exposed end of the at least one channel layer;
forming an interlayer dielectric layer in the source/drain zone, the interlayer dielectric layer straddling the source/drain region and extending along a gate spacer, and the interlayer dielectric layer comprising a third dielectric material;
forming a gate opening between the gate spacers by removing the dummy gate in the gate zone;
depositing a bottom dielectric layer in the gate opening, the bottom dielectric layer comprising a fourth dielectric material;
   wherein the second dielectric material, the third dielectric material, and the fourth dielectric material comprise different materials;
forming a gate structure in the gate opening;
forming a backside source/drain contact to the source/drain region by, from the backside:
   removing the substrate, such that a thinned structure is formed, wherein a backside surface of the thinned structure exposes the second dielectric material of the gate spacers in the gate zone, the third dielectric material of the interlayer dielectric in the source/drain zone, and the fourth dielectric material of the bottom dielectric layer in the gate zone;
   forming a source/drain contact trench in the source/drain zone, wherein forming the source/drain contact trench comprises selectively etching the fin base by an etchant having a high etch rate on the fin base and a low etch rate on the second and fourth dielectric materials; and
   forming, in the source/drain contact trench, the backside source/drain contact to the source/drain region.

The semiconductor device may herein be a field-effect transistor (FET) device.

The FET device may herein be a nanosheet FET (NSFET) device. The NSFET device comprises at least one channel, in the form of a nanosheet, extending horizontally between a source region and a drain region. The gate of the NSFET device may extend around each channel to form a gate-all-around (GAA).

The FET device may alternatively be a FET device comprising a stack of NSFET devices comprising at least a first and a second NSFET device, the second NSFET device being stacked on top of the first NSFET device. Such a FET device may herein be, for example, a complementary FET (CFET) device, wherein one NSFET device of the stack of NSFET devices is p-type and the other is n-type.

The FET device may alternatively be a forksheet FET device. The forksheet FET device comprises a pair of transistors being arranged side by side, in relatively close proximity, and separated by an insulating wall. Each of the pair of transistors comprise at least one channel, in the form of a nanosheet, extending horizontally between a source region and a drain region. Each transistor of the pair of transistors is controlled by a fork-shaped gate arranged at three sides of the channels.

The substrate may be a silicon substrate. The substrate, and thereby the semiconductor device may form part of a wafer, although it is contemplated that this need not be the case. The semiconductor substrate may be formed on the wafer. The wafer may comprise a plurality of semiconductor devices. Whenever there is a reference to the substrate having a frontside and a backside, this may be construed as the semiconductor device or the wafer also having a frontside and a backside.

The fin may be arranged on top of the substrate. The fin may form a layer stack. The fin comprises at least one channel layer. The fin may comprise at least one sacrificial layer. The fin may be formed by performing conventional lithography and etching processes as known in the art. The fin comprises a fin base. The fin base may be part of the substrate. Alternatively, it is conceivable that the fin may be formed such that the fin base does not form part of the substrate. In other words, the fin may be formed such that the fin base and the substrate are separate entities. For instance, the fin base could be formed of Si, and arranged on top of a silicon-on-insulator (SOI) layer. The fin may be said to form an active part of the completed semiconductor device. After performing the lithography and etching processes, a plurality of fins may be arranged adjacent to each other on the wafer. Sacrificial layers may be layers intended to be removed by etching selectively said layers to the channel layers in order to form "released" or "suspended" channel layer portions in the layer stack before completion of the semiconductor device. Such released/suspended channel layer portions may be provided with wrap-around-gates (i.e. GAA). The sacrificial layers may be SiGe layers. The channel layers may be Si layers. The channel layers may be patterned such that the channel layers form nanosheets.

The substrate may be divided into different zones, i.e. gate zones and source/drain zones.

The gate zone is intended to, in the finished device, comprise a completed gate structure.

The source/drain zone is intended to, in the finished device, comprise a completed source/drain region.

The gate zone may be arranged adjacent the source/drain zone.

The semiconductor device may be divided into several gate zones and source/drain zones. The gate zones and the source/drain zones may be arranged one after another in an alternating manner across the semiconductor device. Accordingly, as seen from a frontside of the substrate, the fin is intended to traverse the gate zones and the source/drain zones.

The first aspect of the invention is based on the insight that prior art schemes for backside patterning require stringent alignment requirements. In order to illustrate one of many advantages with the present method, consider the following.

A frontside of the wafer comprises a plurality of semiconductor devices. The respective semiconductor device comprises a not yet functional gate structure in a gate zone thereof and not yet functional source/drain regions in source/drain regions thereof. It follows that the semiconductor device is not yet functional and may thus be described as being an intermediate device. For instance, contacts to the gate structure and the source/drain regions need be formed. In the context of stacked FET devices, such as the CFET, contacts to gate structure and the source/drain regions of the top FET are normally done from the frontside of the wafer. However, forming contacts to the bottom FET (closest to the substrate) entails flipping the wafer. In subsequent processing steps, the backside surface is patterned in accordance with conventional lithography and etching steps. This may involve forming a mask on the backside surface, and forming holes to expose the source/drain regions. Contacts may subsequently be formed to the source/drain regions. In such prior art schemes, it is, however, challenging to form holes such that they are aligned, in both an X-direction and Y-direction, with the source/drain regions. To this end, the holes will usually expose more than only the source/drain regions. The holes may, for instance, expose adjacent regions of the source/drain regions. During subsequent etching processes (in order to form contacts to the source/drain regions, said act of etching may also etch those adjacent regions. Such adjacent regions may be crucial to ensure proper electrical isolation of the semiconductor device. Hence, the act of etching said adjacent regions is undesired. It is therefore an objective to align, in both the X-direction and Y-direction, the holes to the source/drain regions, and only the source/drain regions, to the greatest extent as possible. However, alignment is still a major challenge with prior art methods.

The present method obviates this alignment problem. Accordingly, a general concept of the invention is to provide a material contrast on the backside that can be used to self-align a backside source/drain contact. This is done by depositing second, third and fourth dielectric materials being different from each other. Hence, a material contrast may be created. This material contrast may be exposed from the backside by removing the substrate and thus, an X-Y grid defined by the crossing of the gate (spacers) and the fin base may be provided. This material contrast is utilized when forming the source/drain contact trenches in the sense that the material contrast introduces etch selectivity. Further to this, the act of depositing a plurality of dielectric materials being different from each other, introduces a considerable etch selectivity. Hence, even if adjacent regions to the source/drain regions are exposed during patterning, these will not be etched when forming the contacts to the source/drain regions. Further, the present method relaxes the alignment requirements. The etch selectivity introduced by the different dielectric materials will ensure that the intended material is etched. It may therefore be expressed that the source/drain contacts are self-aligned with respect to the source/drain regions. The reliance on the material contrast imposes a constraint on the position of the trenches, thus facilitating area selective formation of the contacts.

The term "active part" here refers to regions of the semiconductor device where the electrical properties thereof can be controlled and manipulated to perform functions such as amplification and switching. In this regard, the fin will generally constitute the active part.

The term "self-align" is herein meant that when forming the source/drain contact trenches (and thus the source/drain contacts) in the backside surface, these will be aligned with the source/drain regions in the frontside surface by utilizing the material contrast. Hence, a general concept of the invention is to provide a material contrast on the backside that can be used to self-align a backside source/drain contact.

By etching or removing a first feature or material selectivity to a second feature or material is hereby meant that an etch rate of the first feature or material is greater than an etch rate of the second feature or material, when exposed to the selective etching process. Etching or removing a first feature or material selectively to a second feature or material may imply an etch rate ratio of 10:1, 50:1, 100:1 or greater, a greater ratio indicating a greater selectivity. The selectivity of an etchant may be expressed in different ways. As discuss herein, an etchant may be described in terms of "high" etch rate and "low" etch rate. Accordingly, an etchant having a high etch rate on a first material and a low etch rate on a second material may, similarly, imply an etch rate ratio of 10:1, 50:1, 100:1 or greater, a greater ratio indicating a greater selectivity. Hence, by an etchant having a high etch rate on a first material and a low etch rate on a second material, it is generally meant that a substantial portion of the first material will be removed when etched by said etchant, while a substantial portion of the second material will remain.

Relative spatial terms such as "topmost", "bottom", "lower", "vertical", "stacked on top of", are herein to be understood as denoting locations or directions within a frame of reference of the semiconductor substrate, and more specifically when that semiconductor substrate assumes an intended position which entails the frontside of the semiconductor substrate facing towards a Z-direction. In particular, the terms may be understood in relation to a normal direction to the substrate on which the fin is formed, or equivalently in relation to a bottom-up/stacking direction of the fin. Correspondingly, terms such as "lateral" and "horizontal" are to be understood as locations or directions parallel to the substrate.

The at least one channel layer may comprise a first channel layer and a second channel layer, the second channel layer being arranged above the first channel layer;
wherein the source/drain region comprises a first source/drain region associated with the first channel layer and a second source/drain region associated with the second channel layer, the second source/drain region being arranged above of the first source/drain region;
wherein the backside source/drain contact is a contact to the first source/drain region; and wherein the method further comprises:
   forming a frontside source/drain contact to the second source/drain region.

The first channel layer may form part of a bottom FET device.

The second channel layer may form part of a top FET device. Hence, the semiconductor device may be, or be used to form, a stack of FETs in the form of a bottom FET and a top FET. The bottom FET may be a NFET, and the top FET may be a PFET, or vice versa. Thus, the semiconductor device may be, or be used to form, a CFET.

The use of first, second, etc., are mainly to be seen as labels facilitating reading and that it does not necessarily mean that there needs to be further/all the intervening numbers of portions present. To this end, the fin is not limited to comprising one or two channel layers. In fact, the fin may comprise more than two channel layers. For instance, the fin may comprise three, four, or five channel layers. The channel layers may be separated from each other by means of a dielectric layer.

The act of forming the STI may comprise recessing, in the gate zone and the source/drain zone, the STI to a level at least 15 nm below a bottommost channel layer of the fin.

The STI may be formed subsequently to forming the fin. Forming the fin on the substrate may comprise epitaxially growing a layer stack on a wafer. Forming the fin may comprise etching out the fin from the layer stack. Said etching may extend to a level below the bottom-most channel layer. Thus, the remaining material of the fin, below the bottom-most channel layer, may form the fin base. Adjacent to the fin base, recesses may be formed. The STI may be formed in these recesses in such a way that the STI extends along a respective side of the fin base.

By way of example, the STI may be recessed to a level greater than 20, 30, or 40 nm below the bottommost channel layer of the fin. This facilitates subsequent processing steps, such as the removal of the substrate. By way of another example, the STI may be recessed to a level such that the STI is completely removed.

The act of forming the source/drain contact trench in the source/drain zone may comprise:
forming a mask on the backside surface of the thinned structure, the mask comprising a hole exposing part of the source/drain zone and part of the gate zone on the backside surface of the thinned structure;
selectively etching in the hole of the mask by the etchant having a high etch rate on the fin base and a low etch rate on the second and fourth dielectric materials.

The hole is formed in the mask so as to expose the source/drain regions. Hence, source/drain contact trenches (and subsequently contacts) to the source/drain regions may be formed. Due to the merit of the material contrast, the hole need not be perfectly aligned with the source/drain region. It is conceivable that the hole is slightly misaligned. In that case, since the etchant is selective, the source/drain contact trenches will, in any case, be sufficiently aligned with the source/drain regions so as to enable adequate contact formation. As noted above, the source/drain contact trenches (source/drain contacts) may be described as being self-aligned. In other words, the reliance on the material contrast imposes a constraint on the position of the trenches, thus facilitating area selective formation of the contacts.

The first dielectric material of the STI may comprise at least one of: SiO₂, SiO.

The second dielectric material of the gate spacers may comprise at least one of: Si₃N₄, SiOC, SiOCN, SiOBCN.

The third dielectric material of the interlayer dielectric layer may comprise at least one of: SiO₂, SiOC.

The fourth dielectric material of the bottom dielectric layer may comprise at least one of: Si₃N₄, SiOC, SiOCN, SiOBCN, SiCN.

The first dielectric material of the STI may comprise the same material as the third dielectric material of the interlayer dielectric layer.

The method may further comprise
depositing a dummy gate oxide in the gate zone, the dummy gate oxide being deposited between the acts of forming the STI in the gate zone and the source/drain zone and forming the dummy gate on the STI in the gate zone.

The dummy gate oxide may increase a process margin for the act of removing the dummy gate, such that unintentional etching of the fin (comprising the active parts) during removal of the dummy gate may be avoided. In particular, the dummy gate oxide may be used as an etch stop layer in the case that the dummy gate is removed by means of performing an etching. The dummy gate oxide may similarly protect the STI during the removal of the dummy gate. In addition, the dummy gate oxide may act as an etch stop layer and/or further improve etch selectivity when removing remaining STI during substrate removal.

The act of removing the substrate may be performed by chemical-mechanical polishing, CMP.

In order to improve process control, it is contemplated that the step of removal by CMP may be followed by wet or dry etch.

The act of forming the source/drain contact trench may further comprise:
from the backside:
recessing the fin base to form a fin base recess, wherein recessing the fin base comprises selectively etching the fin base by an etchant having a high etch rate on the fin base and a low etch rate on the second and fourth dielectric materials;
depositing a fifth dielectric material in the fin base recess, the fifth dielectric material being different from the second dielectric material, the third dielectric material, and the fourth dielectric material.

The fifth dielectric material may be different from the material of the fin base. The fifth dielectric material may contribute to an increased material contrast, thus facilitating area selective formation of the contacts further.

The fifth dielectric material may comprise at least one of: SiOC, SiOCN, SiOBCN, Si₃N₄, SiCN.

The dummy gate may comprise amorphous silicon, a-Si.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figs. 1a-b illustrate backside surfaces of an exemplary not yet completed prior art semiconductor device and a not yet completed semiconductor device formed in accordance with a method as disclosed herein.
Figs. 2a-b through 13a-b illustrate the semiconductor device formation steps of a method in schematically depicted cross-sectional views.

### DETAILED DESCRIPTION

In the following the formation of a semiconductor device will be exemplified in the context of a stacked transistor device having a top device and a bottom device. It is noted that such a device will generally comprise top source/drain regions associated with the top device, and bottom source/drain regions associated with the bottom device. The top device, and thus the top source/drain regions, will also generally be arranged above the bottom device and the bottom source/drain regions. Such a device may be a CFET (Complementary FET) but other devices having a similar stacked structure may be contemplated. It is noted that the method may be applied in parallel to any number of semiconductor devices which may be formed on the substrate, or the wafer. In the following, it should be noted that any references to the term "semiconductor device" need not imply that the semiconductor device is necessarily completed.

In the figures discussed below, axes X, Y and Z indicate a first direction, a second direction transverse to the first direction, and a vertical or bottom-up direction, respectively. The X- and Y-direction may in particular be referred to as lateral or horizontal directions in that they are parallel to a main plane of the substrate. The Z-direction is parallel to a normal direction of the frontside of the substrate. In the finished devices, the current flows in the X-direction.

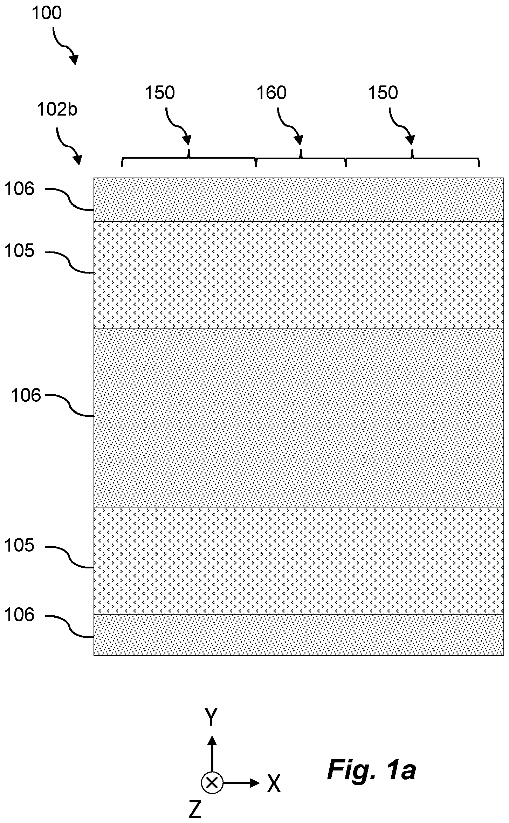

Referring now to Fig. 1a, an exemplary not yet completed prior art semiconductor device PA is illustrated. More specifically, a backside surface 102b of the semiconductor device PA is shown. Here, the semiconductor device PA is viewed along the Z-axis. This direction is perpendicular to the plane formed by the X- and Y-axes. Two fin bases 105, being part of a respective fin, are exposed. The two fin bases 105 extends across gate zones 150 and source/drain zones 160. Each of the fin bases 105 is part of a respective fin. The fins may protrude in the Z-direction (as seen from a frontside of the semiconductor device PA). The fin is a layer stack comprising channel layers, a functional gate structures, and source/drain regions. The backside surface 102b may have been subject to any suitable planarization methods, such as chemical-mechanical polishing, CMP. Hence, the backside surface 102b may be planarized. The X-axis represents a direction in which a current is to flow from one source/drain region to another source/drain region. The fin has a top device and a bottom device, each representing opposite conductivity types (e.g. p-type bottom device and n-type top device, or vice versa). Had the semiconductor device PA been viewed from the frontside instead it would be apparent that the functional gate structures would extend perpendicular to the fins, and extend from one fin to another fin, and further be formed on the fins. The functional gate structures would further be confined to extend in the gate zones 150. Similarly, the source/drain regions would extend perpendicular to the fins, and thereby parallel in relation to the gate structures, and extend from one fin to another fin, and further be formed on the fins. The source/drain regions would further be confined to extend in the source/drain zones 160. Between the fins (fin bases 105), a shallow trench isolation, STI 106 is arranged to provide electrical isolation. The STI 106 is exposed in the backside surface 102b of the semiconductor device PA. The backside surface 102b of the semiconductor device PA exposes two different materials, that of the fin base 105 and that of the STI 106. Hence, it may be said that there is provided a material contrast.

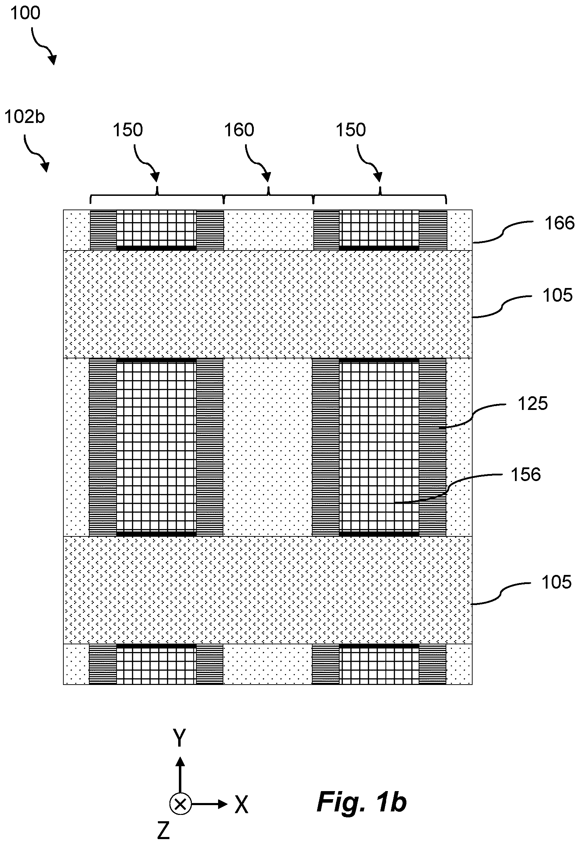

Referring now to Fig. 1b, a not yet completed semiconductor device 100 as formed in accordance with a method as disclosed herein is shown. More specifically, a backside surface 102b of the semiconductor device 100 is shown. In contrast to the prior art semiconductor device PA, the semiconductor device 100 exposes several (i.e. more than two) different materials, thus providing a substantial material contrast compared to the prior art semiconductor device PA. The backside surface 102b of the semiconductor device 100 further exposes (apart from the fin bases 105) gate spacers 125, an interlayer dielectric layer 166, and a bottom dielectric layer 156. As will be apparent in the following discussion, the STI 106 has been removed and is therefore not exposed in the backside surface 102b of the semiconductor device 100.

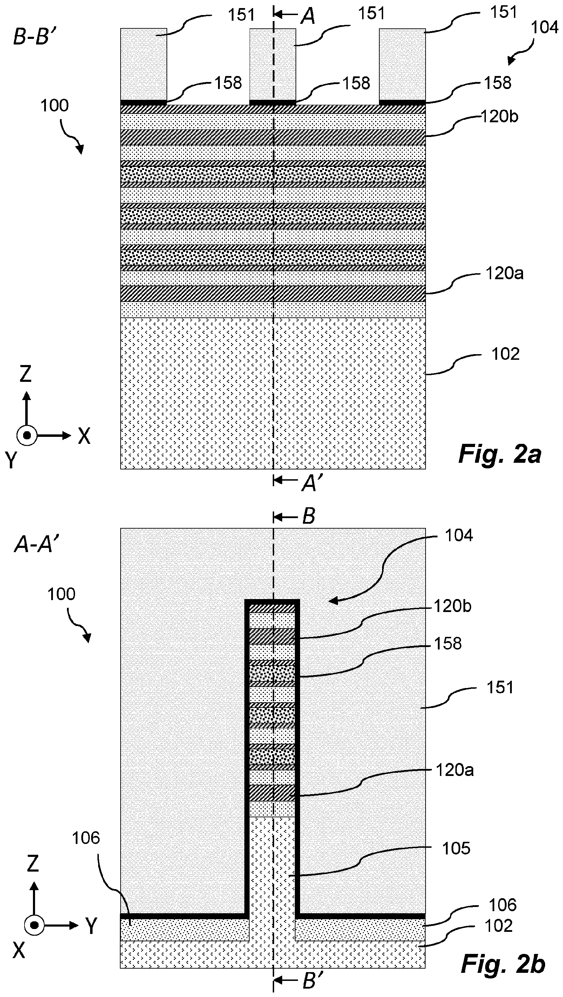

A method for forming the semiconductor device 100 will now be described with reference to Figs. 2a-b through 13a-b schematically illustrating various stages of the method. With reference to Figs. 2a-b, it should be noted that Fig. 2a shows a first cross-section of the semiconductor device 100 along line B-B' indicated in Fig. 2b. Similarly, Fig. 2b shows a second cross-section of the semiconductor device 100 along line A-A' indicated in the Fig. 2a. The X- and Y-axes indicate first and second horizontal directions, respectively, parallel to a main plane of a substrate 102. As discussed above, the X-axis represents a direction in which a current is to flow from one source/drain region to another source/drain region. The Z-axis indicates a normal or vertical direction with respect to the substrate 102. The cross-sections and directions in subsequent figures correspond to those in Fig. 2, unless stated otherwise. Throughout the figures, like fill patterns will be used for like materials, unless stated otherwise.

Figs. 2a-b show the semiconductor device 100 at an initial or starting stage of the method. The semiconductor device 100 is formed on a substrate 102. The substrate 102 may be a conventional semiconductor substrate. The substrate 102 may be a single-layered semiconductor substrate, for instance formed by a bulk substrate such as a Si substrate, a germanium (Ge) substrate or a silicon-germanium (SiGe) substrate. A multilayered / composite substrate is also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The semiconductor device 100 comprises a fin 104 extending along the X-axis and protruding along the Z-axis. The fin 104 comprises a number of channel layers 120a, 120b. The fin 104 comprises a fin base 105 on which the number of channel layers 120a, 120b is arranged.

It is appreciated that the semiconductor device 100 is not restricted to a certain number of channel layers. In this particular case, two channel layers 120a, 120b are schematically illustrated, but the semiconductor device 100 may very much comprise more or less channel layers. The semiconductor device 100 comprises a first channel layer 120a and a second channel layer 120b. The second channel layer 120b is arranged above the first channel layer 120a. The channel layers 120a, 120b are formed as nanosheets but it is contemplated that other geometries may be accommodated with remaining function.

The semiconductor device 100 may further comprise a number of sacrificial layers alternating the channel layers 120a, 120b. It is noted that the number of sacrificial layers, similarly to the number of channel layers 120a, 120b, may be different.

Each of the channel layers 120a, 120b may comprise semiconductor material, e.g. Si. The fin base 105 may comprise semiconductor material, e.g. Si. Forming the fin 104 on the substrate 102 may comprise epitaxially growing a layer stack on a wafer. The bottom-most channel layer 120a may be grown directly on the wafer or on a base layer. The base layer may be epitaxially grown on the wafer. Forming the fin 104 may comprise etching out the fin 104 from the layer stack. Said etching may extend to a level below the bottom-most channel layer 120a. Thus, the remaining material of the fin 104, below the bottom-most channel layer 120a, may form the fin base 105. If the bottom-most channel layer 120a was grown directly on the wafer, the fin base 105 may comprise part of the wafer. If the bottom-most channel layer 120a was grown on a base layer, the fin base 105 may comprise part of the base layer. Accordingly, the substrate 102 may be defined as extending from the bottom level of the fin base 105 to the bottom of the wafer. It is contemplated that the fin base 105 may form part of the substrate 102. To that end, the fin base 105 and the substrate 102 are, in the following figures, illustrated with like fill patterns. Still, it should be noted that the fin base 105 and the substrate 102 need not form a single unit. Indeed, the fin base 105 and the substrate 102 may form separate entities and be formed of different materials. It is noted that several fins 104 may be formed on the substrate 102, or the wafer. These fins 104 may extend in parallel with respect to each other, and with a distance therebetween.

Along the fin 104, a plurality of dummy gates 151 are arranged and straddling the fin 104 along the Y-axis. In this context, by the term "straddling" it is meant that the dummy gates 151 is in contact, either indirectly or directly, with lateral surfaces and a top surface of the fin 104. Each dummy gate 151 are spaced apart from each other a distance along the X-axis. The dummy gate 151 is also formed on the STI 106. The dummy gate 151 may extend from one fin 104 to another adjacent fin 104, thus straddling the another adjacent fin 104. The dummy gate 151 may comprise amorphous silicon, a-Si.

The fin base 105 is surrounded by the STI 106. The STI 106 may be of a first dielectric material 108a e.g. of SiO₂ or another conventional low-k dielectric suitable as a STI 106. The STI 106 is formed to a level being below the bottom most channel layer 120a. This level may be situated at least 15 nm below the channel layer 120a. Hence, further electrical isolation may be provided. Prior to forming the dummy gates 151 on the fin 104, a dummy gate oxide 158 may be deposited on the semiconductor device 100. The dummy gate oxide 158 may be deposited in accordance with a method as known per the art. For instance, the dummy gate oxide 158 may be deposited by conformal coating (e.g. ALD). The dummy gate oxide 158 may alternatively be deposited in accordance with a non-conformal deposition. The dummy gate oxide 158 may straddle the fin 104. The dummy gate oxide 158 may further be deposited on the STI 106. The dummy gate oxide 158 may comprise SiO₂.

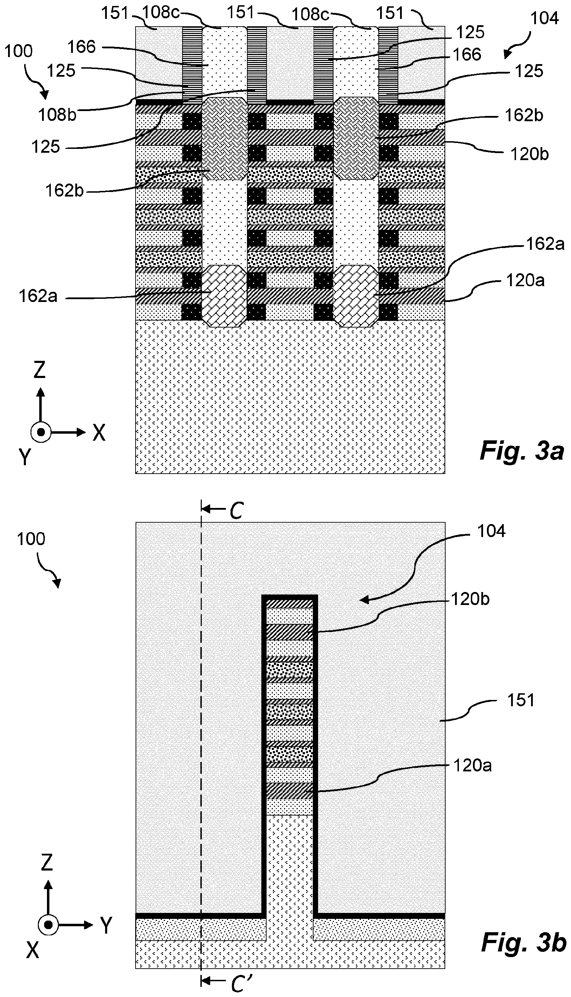

With reference to Figs. 3a-b, the formation of source/drain regions 162 are described. It is appreciated that the formation of source/drain regions is well known in the art and will not be described in greater detail.

In any case, the method further comprises forming gate spacers 125 in the gate zone 150. The gate spacers 125 straddles the fin 104 and extend along opposing sides of the dummy gate 151. The gate spacers 125 comprise a second dielectric material 108b. The second dielectric material 108b may comprise e.g. Si₃N₄, SiOC, SiOCN.

The method further comprises recessing the fin 104 down to the fin base 105 in the source/drain zone 160 to form a source/drain recess exposing ends of the channel layers 120a, 120b.

The method further comprises forming a source/drain region 162 on the exposed ends of the channel layers 120a, 120b.

The source/drain region 162 comprises a first (bottom) source/drain region 162a associated with the first (bottom) channel layer 120a and a second (top) source/drain region 162b associated with the second (top) channel layer 120b. The second source/drain region 162b is arranged above of the first source/drain region 162a.

The method further comprises forming an interlayer dielectric layer 166 in the source/drain zone 160. In doing so, the interlayer dielectric layer 166 straddles the source/drain region 162 and extends along the gate spacers 125. More specifically, the interlayer dielectric layer 166 surrounds the source/drain regions 162a, 162b. The interlayer dielectric layer 166 comprising a third dielectric material 108c. The third dielectric material 108c may comprise e.g. SiO₂ or SiOC.

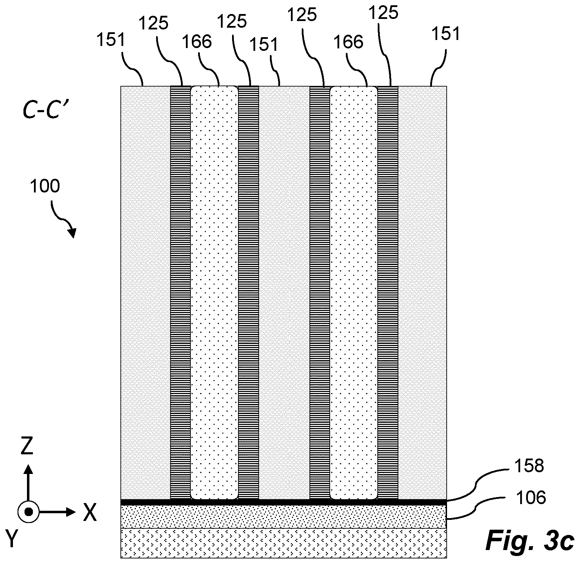

Fig. 3c further illustrates the semiconductor device 100 in another cross-section. More specifically, Fig.3c shows a third cross-section of the semiconductor device 100 along line C-C' indicated in Fig. 3b This view is parallel with the XZ-plane and serves to highlight a cross-section of the semiconductor device 100 adjacent to the fin 104, or alternatively expressed between adjacent fins 104.

The dummy gates 151, the gate spacers 125, and the interlayer dielectric layer 166 may be formed on the dummy gate oxide 158, above the STI 106. It is implied that the dummy gates 151, the gate spacers 125, and the interlayer dielectric layer 166 extend from fin 104 to another adjacent fin 104 in the Y-direction.

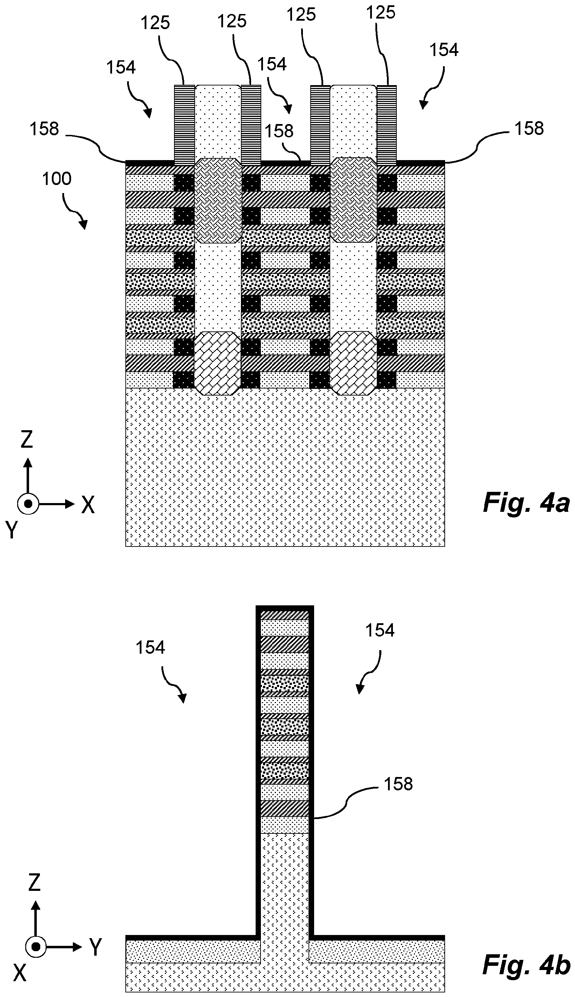

With reference to Figs. 4a-b, the method further comprises forming a gate opening 154 between the gate spacers 125 by removing the dummy gate 151 in the gate zone 150. Removal of the dummy gate 151 may be performed by selective etching by an etchant selective with respect to the dummy gate 151. The term "selective" in connection with "removal" or "etching" of a layer or a material is to be understood as a removal of the layer or the material by a selective etching process, wherein a removal rate / etch rate of the layer or the material to be selectively removed / etched exceeds a removal rate / etch rate of at least one other layer or material exposed to the etching process. In doing so, the dummy gate oxide 158 is exposed. Ultimately, the semiconductor device 100 may further be subject to a gate etch process in subsequent semiconductor processing steps in order to form a final gate structure. Accordingly, the dummy gate 151 (sacrificial gate structure) is intended to be replaced by a functional/final gate. In this context, the term "functional gate structure" or "final gate structure" here refers to a gate structure providing the function of a gate in the finished devices. The functional gate structure may comprise a first gate stack (e.g. including a P-type WFM) arranged in a first device region (e.g. a P-type region) and a second gate stack (e.g. including an N-type WFM) arranged in a second device region (e.g. an N-type region). The functional gate structure may be replacement metal gate structure.

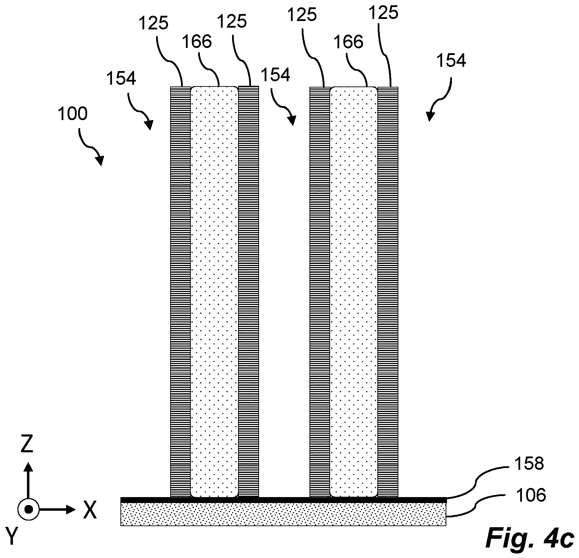

Fig. 4c further illustrates the semiconductor device 100 in the third cross-section.

It is implied that the removal of the dummy gate 151 will also remove any portions of the dummy gate 151 that is formed between adjacent fins 104 and extending in the Y-direction. In this cross-section, the gate spacers 125 and the interlayer dielectric layer 166 remain between adjacent fins 104. The gate openings 154 are also present in the third cross-section.

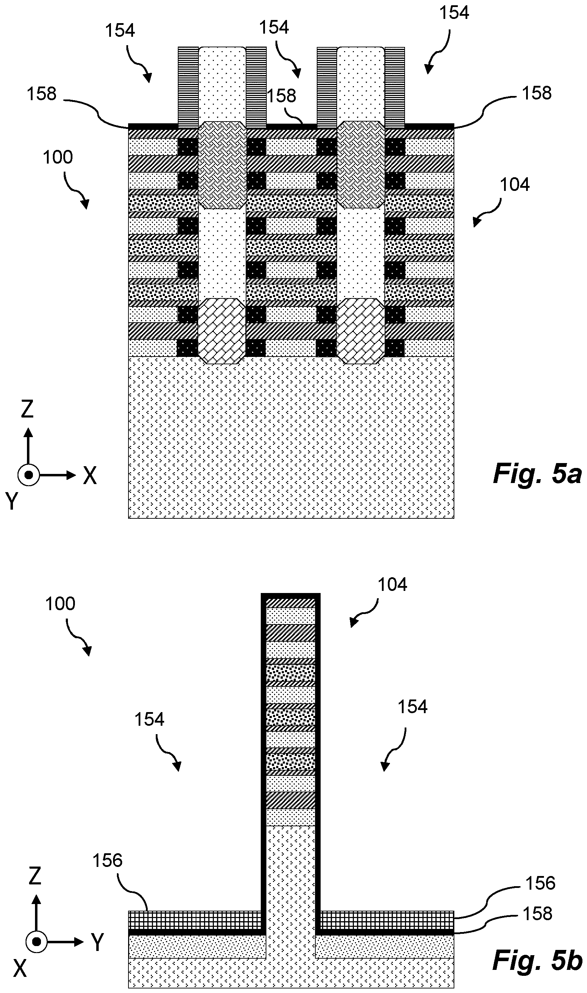

With reference to Figs. 5a-b, the method further comprises depositing a bottom dielectric layer 156 in the gate opening 154. The bottom dielectric layer 156 may be formed as a layer of epitaxial (i.e. epitaxially grown/formed/deposited) semiconductor material. The formation of the bottom dielectric layer 156 may be performed by any suitable deposition process such as physical vapor deposition (PVD) or chemical vapor deposition (CVD). The bottom dielectric layer 156 may be deposited on a respective side of the fin 104. The bottom dielectric layer 156 comprises a fourth dielectric material 108d. The fourth dielectric material 108d may comprise e.g. Si₃N₄, SiOC, SiOCN, SiOBCN. The bottom dielectric layer 156 may be deposited on top of the dummy gate oxide 158. The bottom dielectric layer 156 may further be in physical contact with the dummy gate oxide 158 that has been deposited on the fin 104.

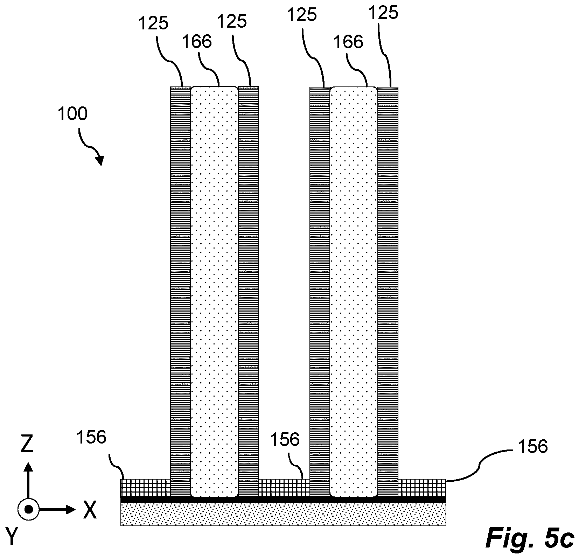

Fig. 5c further illustrates the semiconductor device 100 in the third cross-section.

It is implied that the bottom dielectric layer 156 will be deposited between the gate spacers 125 in the gate zone and outside the S/D zone.

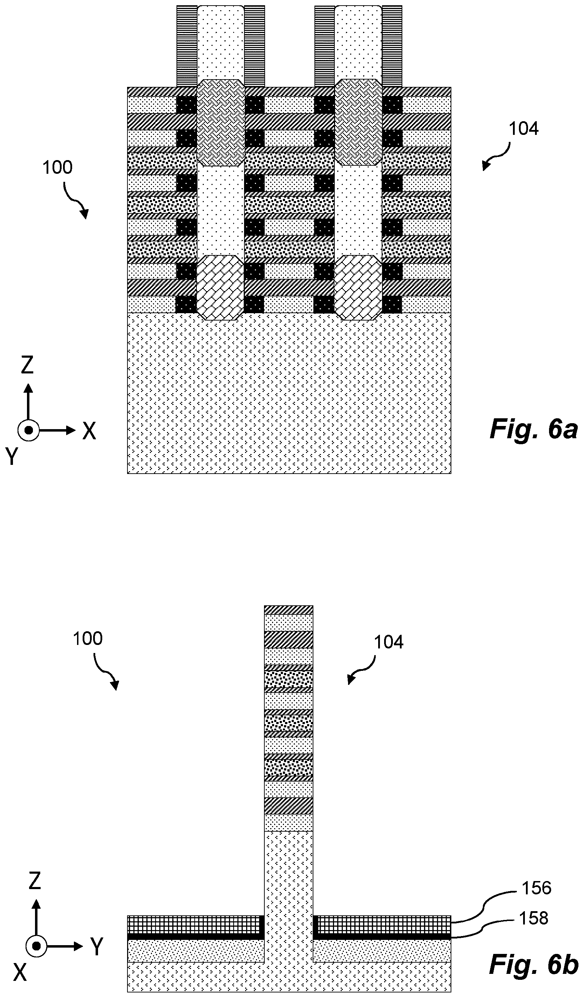

With reference to Figs. 6a-b, the method may further comprise removing any dummy gate oxide 158 that is exposed. More specifically, a portion of the dummy gate oxide 158 deposited on the fin 104 may be removed thereby exposing the fin 104. The portion of the dummy gate oxide 158 deposited on the STI 106 is masked by the bottom dielectric layer 156 and will therefore remain. The removal of the dummy gate oxide 158 may be performed by a selective etch step.

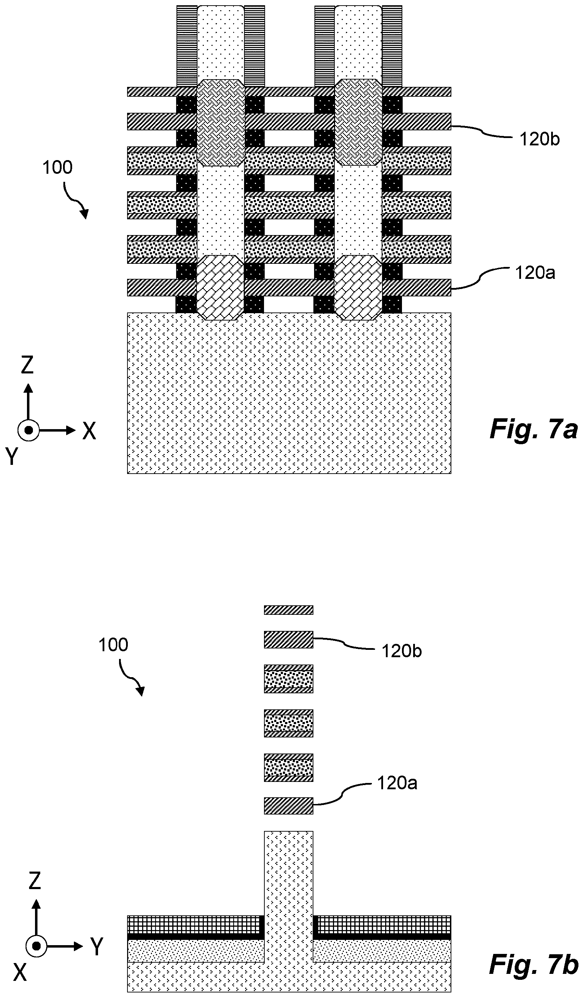

With reference to Figs. 7a-b, the method may further comprise removing, or "releasing", the sacrificial layers arranged between the channel layers 120a, 120b.

As discussed herein, removal of the sacrificial layers may be performed by selective etching. Etching selectively the sacrificial layers to the channel layers 120a, 120b layers in order to form "released" or "suspended" channel layers 120a, 120b in the layer stack may be performed before completion of the device. Such released/suspended channel layers 120a, 120b may be provided with wrap-around-gates (i.e. GAA). It is appreciated that the act of "releasing" channel layers is known per art and will not be further discussed in greater detail. The act of removing the sacrificial layers will form recesses between the channel layers 120a, 120b.

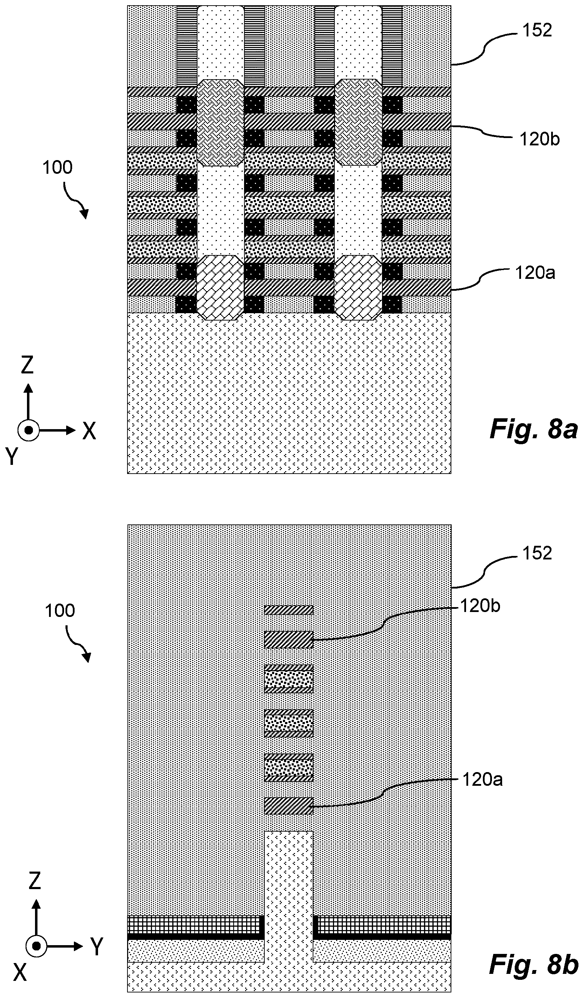

With reference to Figs. 8a-b, the method further comprises forming a gate structure 152 in the gate opening 154. The gate structure 152 may be functional. In doing so, the gate structure 152 will also be formed in the recesses between the channel layers 120a, 120b. In other words, the sacrificial layers may be said to have been replaced with another material. The formation of such a gate structure 152 is known in the art. For instance, the gate structure 152 may be formed by performing remaining steps of a conventional replacement metal gate, RMG, process.

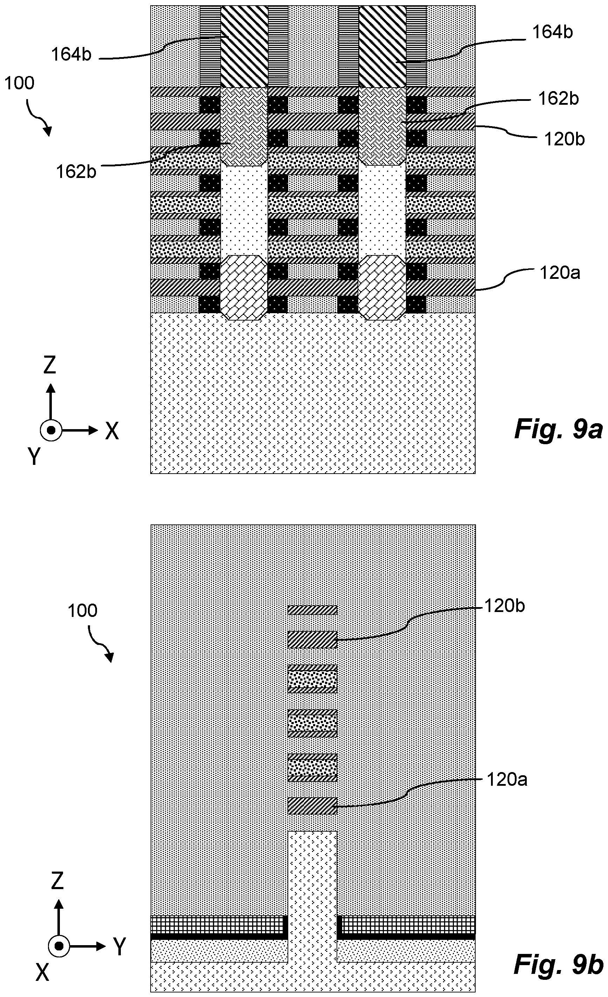

With reference to Figs. 9a-b, the method may further comprise forming frontside source/drain contacts 164b to the second (top) source/drain regions 162b associated with the second (top) channel layers 120b. This may be performed by initially removing, by selective etching, an exposed portion of the interlayer dielectric layer 166 that has been formed on the second source/drain regions 162b. This step may be followed by a contact metal deposition over the top source/drain regions 162b.

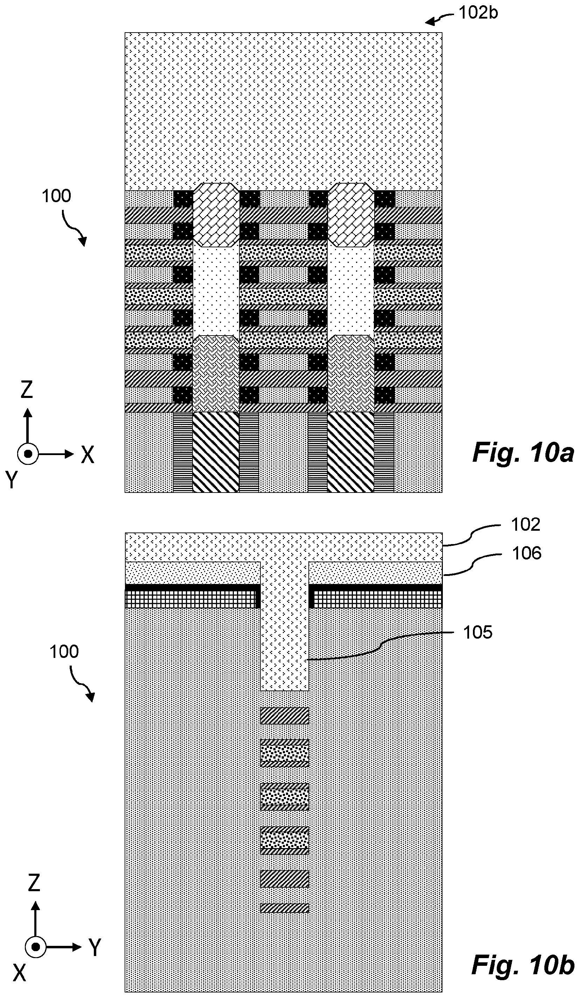

With reference to Figs. 10a-b, the method may further comprise flipping the semiconductor device 100. Since the semiconductor device 100, as discussed in various levels of details above, may be formed on a wafer, it is implied that the wafer may thusly be flipped. Hence, further processing steps may be performed on a backside surface 102b of the semiconductor device 100 (or wafer).

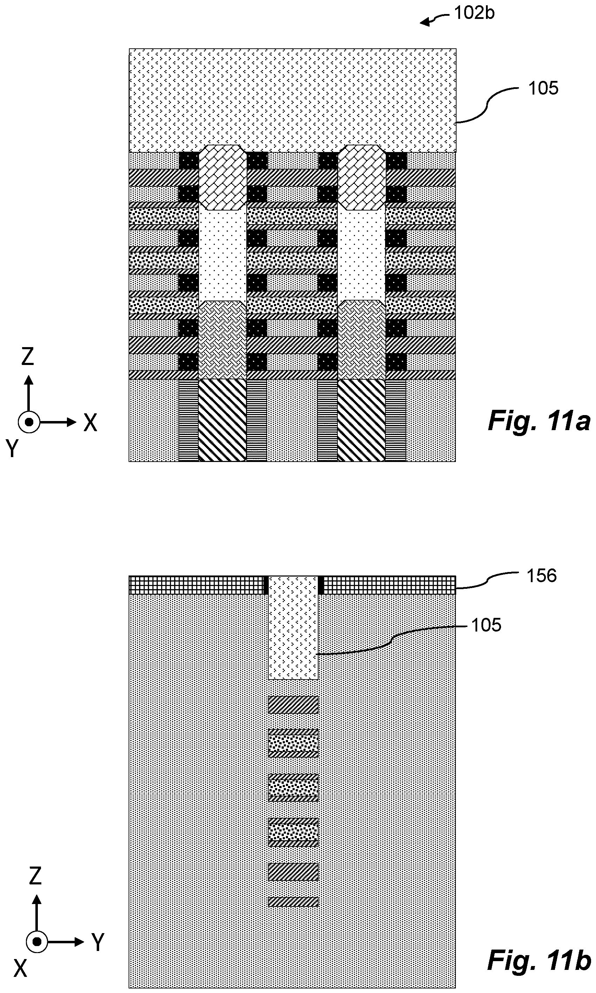

With reference to Figs. 11a-b, the method further comprises removing the substrate 102, such that a thinned structure is formed. The act of removing the substrate 102 may be performed by chemical-mechanical polishing, CMP. Hence, the backside surface 102b may be planarized. In order to improve process control, it is contemplated that the step of removal by CMP may be followed by wet or dry etch. As discussed above, the substrate 102 may be defined as extending from the bottom level of the fin base 105 to the bottom of the wafer. The removal of the substrate 102 may be performed to such an extent that a portion of the dummy gate oxide 158 is removed, hence exposing the bottom dielectric layer 156. It is further implied that the fin base 105 is exposed due to the removal of the substrate 102. It is contemplated that removal of the substrate 102 may continue and further etch away a portion of the exposed bottom dielectric layer 156 and the fin base 105.

It should be noted that the act of removing the substrate 102 may also entail removing the STI 1 06.

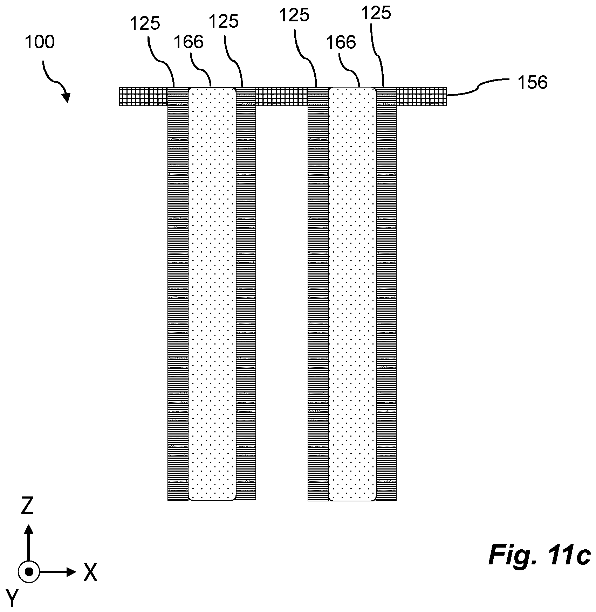

Fig. 11c further illustrates the semiconductor device 100 in the third cross-section.

It is implied that removal of the substrate 102 will not only expose the bottom dielectric layer 156, but also the interlayer dielectric layer 166 and the gate spacers 125.

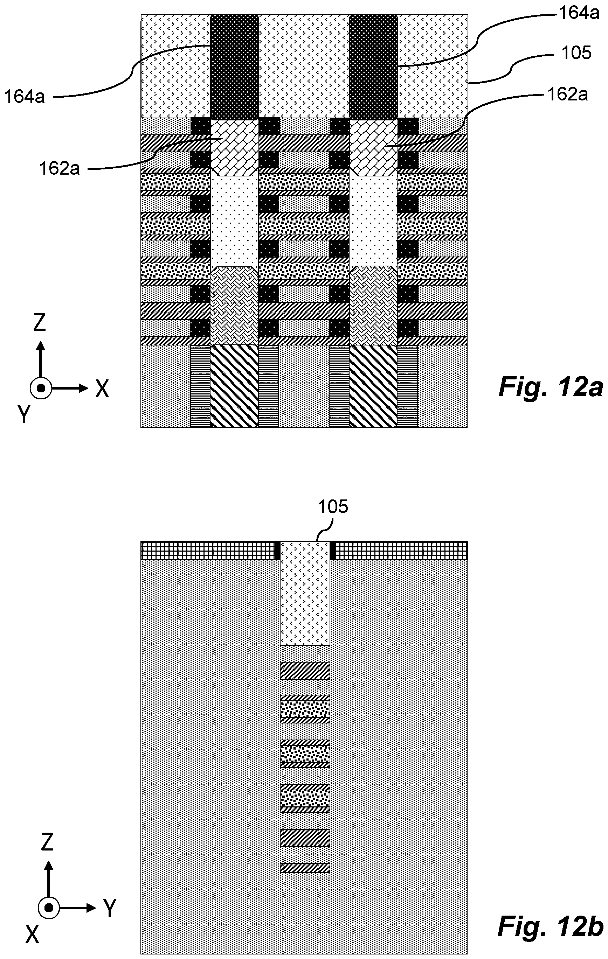

Figs. 12a-b illustrate the formation of a backside source/drain contact 164a to the first source/drain region 162a. Accordingly, formation of the backside source/drain contact 164a is preceded by the act of forming a source/drain contact trench in the source/drain zone 160. The method further comprises forming, in the source/drain contact trench, the backside source/drain contact 164a to the first source/drain region 162a. The backside source/drain contact 164a may be formed by a contact metal deposition over the first source/drain region 162a.

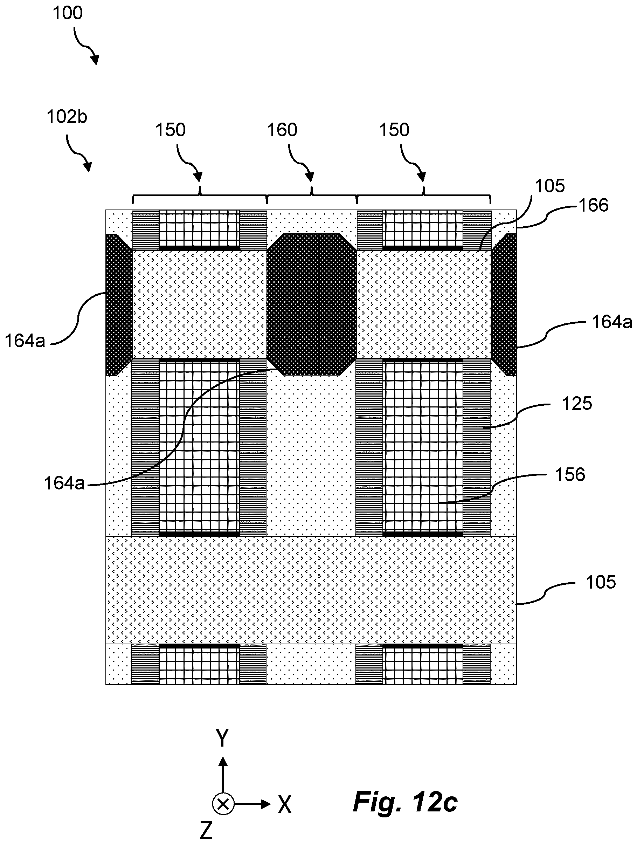

Fig. 12c illustrates the backside surface 102b after having formed the backside source/drain contact 164a to the first source/drain region 162a. Fig. 12c illustrates the formation of backside source/drain contacts 164 only in the top fin base 105 but it is contemplated that backside source/drain contacts 164 may be formed in the lower fin base 105 as well. The act of forming the source/drain contact trench comprises selectively etching the fin base 105 by an etchant having a high etch rate on the fin base 105 and a low etch rate on the second (gate spacers 125) and fourth (bottom dielectric layer 156) dielectric materials 108b, 108d.

It is apparent that the backside surface 102b of the thinned structure exposes the second dielectric material 108b of the gate spacers 125 in the gate zone 150, the third dielectric material 108c of the interlayer dielectric 166 in the source/drain zone 160, and the fourth dielectric material 108d of the bottom dielectric layer 156 in the gate zone 160. Although the STI 106 has been removed and is therefore not shown in Fig. 12c, in general, the material of the fin base 105, the first, second, third, and fourth dielectric materials 108a, 108b, 108c, 108d may all be different materials. To this end, a substantial material contrast has been formed.

Although omitted from the figures, in order to provide more precise alignment of the backside source/drain contact 164a relative to the first source/drain region 162a, the act of forming the source/drain contact trench may comprise forming a mask on the backside surface 102b of the thinned structure. The mask may be a hard mask. Example mask materials include nitride materials such as SiN, or another conventional hard mask material suitable for patterning, e.g. SiO2 or a-Si. Example patterning techniques for the hard mask HM include single-patterning techniques, e.g. lithography and etching, and multiple patterning techniques, e.g. self-aligned double or quadruple patterning (SADP or SAQP). The mask comprises a hole exposing part of the source/drain zone 160 and part of the gate zone 150 on the backside surface 102b of the thinned structure. The method may further comprise selectively etching in the hole of the mask by the etchant having a high etch rate on the fin base 105 and a low etch rate on the second and fourth dielectric materials 108b, 108d.

Irrespective of whether the method comprises forming a mask or not, it is contemplated that formation of the backside source/drain contact 164a may involve (unintentionally) etching the third dielectric material 108c of the interlayer dielectric material 166, and thus removing a portion of it. Accordingly, it is contemplated that the etchant may have a high etch rate on the third dielectric material 108c of the interlayer dielectric layer 166, but it is also contemplated that the etch rate may be low thus implying that a small portion of the interlayer dielectric layer 166 is removed. It is further contemplated that the backside source/drain contact 164a may cover more or less a greater surface area than that depicted in Fig. 12c.

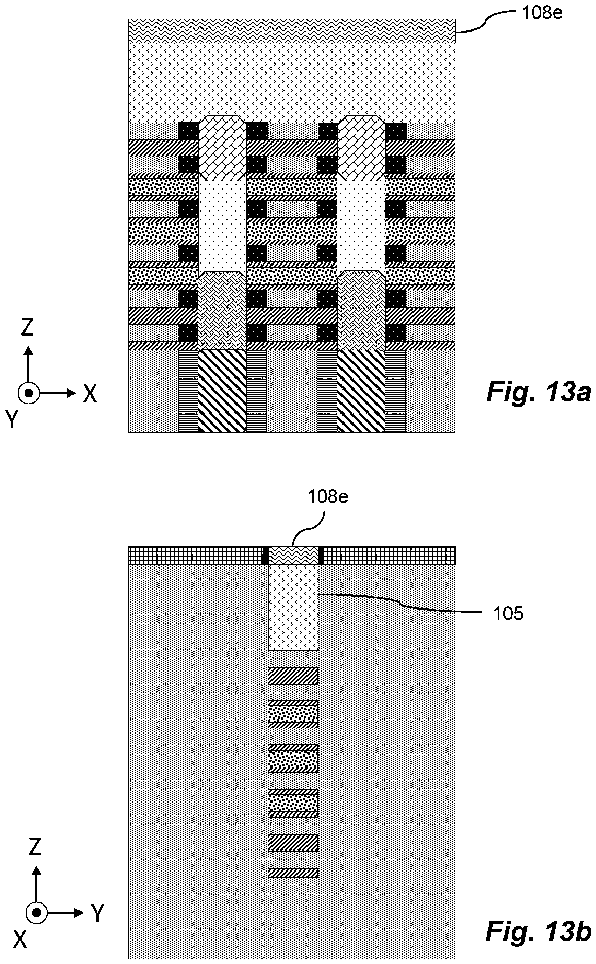

Figs. 13a-b illustrate the formation of yet another dielectric material, i.e. a fifth dielectric material 108e. Such formation may be performed prior to forming the source/drain contact trench and the backside source/drain contact 164a. Said formation of the fifth dielectric material 108e may comprise recessing the exposed fin base 105 to form a fin base recess. Recessing the fin base 105 may comprise selectively etching the fin base 105 by an etchant having a high etch rate on the fin base 105 and a low etch rate on the second (gate spacers 125) and fourth (interlayer dielectric layer 166) dielectric materials 108b, 108d. The method may further comprise depositing a fifth dielectric material 108e in the fin base recess. The fifth dielectric material 108e may be different from the material of the fin base 105, the second dielectric material 108b, the third dielectric material 108c, and the fourth dielectric material 108d. Hence, an even more substantial material contrast may be provided. The fifth dielectric material 108e may also be different from the first dielectric material 108a of the STI 106. The fifth dielectric material 108e may comprise e.g. SiOC, SiOCN, SiOBCN, Si₃N₄, or SiCN.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor device (100), comprising:
providing a substrate (102) having a frontside (102a) and a backside (102b);
forming a fin (104) on the frontside (102a) of the substrate (102), the fin (104) comprising a fin base (105) and at least one channel layer (120) arranged on the fin base (105);
forming a shallow trench isolation, STI (106), the STI (106) being arranged adjacent to the fin base (105) and extending along the fin base (105), the STI (106) comprising a first dielectric material (108a), the fin (104) and the STI (106) extending across a gate zone (150) and across a source/drain zone (160);
forming a dummy gate (151) on the STI (106) in the gate zone (150), the dummy gate (151) straddling the fin (104);
forming gate spacers (125) in the gate zone (150), the gate spacers (125) straddling the fin (104) and extending along opposing sides of the dummy gate (151), and the gate spacers (125) comprising a second dielectric material (108b);
recessing the fin (104) in the source/drain zone (160) to form a source/drain recess (161) exposing an end (122) of the at least one channel layer (120) and forming a source/drain region (162) on the exposed end (122) of the at least one channel layer (120);
forming an interlayer dielectric layer (166) in the source/drain zone (160), the interlayer dielectric layer (166) straddling the source/drain region (162) and extending along a gate spacer (125), and the interlayer dielectric layer (166) comprising a third dielectric material (108c);
forming a gate opening (154) between the gate spacers (125) by removing the dummy gate (151) in the gate zone (150);
depositing a bottom dielectric layer (156) in the gate opening (154), the bottom dielectric layer (156) comprising a fourth dielectric material (108d);
wherein the second dielectric material (108b), the third dielectric material (108c), and the fourth dielectric material (108d) comprise different materials;
forming a gate structure (152) in the gate opening (154);
forming a backside source/drain contact (164) to the source/drain region (162) by, from the backside (102b):
removing the substrate (102), such that a thinned structure is formed, wherein a backside surface of the thinned structure exposes the second dielectric material (108b) of the gate spacers (125) in the gate zone (150), the third dielectric material (108c) of the interlayer dielectric (166) in the source/drain zone (160), and the fourth dielectric material (108d) of the bottom dielectric layer (156) in the gate zone (160);
forming a source/drain contact trench (166) in the source/drain zone (160), wherein forming the source/drain contact trench (166) comprises selectively etching the fin base (105) by an etchant having a high etch rate on the fin base (105) and a low etch rate on the second and fourth dielectric materials (108b, 108d); and
forming, in the source/drain contact trench (166), the backside source/drain contact (164) to the source/drain region (162).

2. The method according to claim 1, wherein the at least one channel layer (120) comprises a first channel layer (120a) and a second channel layer (120b), the second channel layer (120b) being arranged above the first channel layer (120a);
wherein the source/drain region (162) comprises a first source/drain region (162a) associated with the first channel layer (120a) and a second source/drain region (162b) associated with the second channel layer (120b), the second source/drain region (162b) being arranged above of the first source/drain region (162a);
wherein the backside source/drain contact (164a) is a contact to the first source/drain region (162a); and wherein the method further comprises:
forming a frontside source/drain contact (164b) to the second source/drain region (162b).

3. The method according to any one of claims 1-2, wherein the act of forming the STI (106) comprises recessing, in the gate zone (150) and the source/drain zone (160), the STI (106) to a level at least 15 nm below a bottommost channel layer (120) of the fin (104).

4. The method according to any one of the preceding claims, wherein the act of forming the source/drain contact trench (166) in the source/drain zone (160) comprises:
forming a mask on the backside surface of the thinned structure, the mask comprising a hole exposing part of the source/drain zone (160) and part of the gate zone (150) on the backside surface of the thinned structure;
selectively etching in the hole of the mask by the etchant having a high etch rate on the fin base (105) and a low etch rate on the second and fourth dielectric materials (108b, 108d).

5. The method according to any one of the preceding claims, wherein the first dielectric material (108a) of the STI (106) comprises at least one of: SiO₂, SiO.

6. The method according to any one of the preceding claims, wherein the second dielectric material (108b) of the gate spacers (125) comprises at least one of: Si₃N₄, SiOC, SiOCN, SiOBCN.

7. The method according to any one of the preceding claims, wherein the third dielectric material (108c) of the interlayer dielectric layer (166) comprises at least one of: SiO₂, SiOC.

8. The method according to any one of the preceding claims, wherein the fourth dielectric material (108d) of the bottom dielectric layer (156) comprises at least one of: Si₃N₄, SiOC, SiOCN, SiOBCN, SiCN.

9. The method according to any one of the preceding claims, wherein the first dielectric material (108a) of the STI (106) comprises the same material as the third dielectric material (108c) of the interlayer dielectric layer (166).

10. The method according to any one of the preceding claims, further comprising
depositing a dummy gate oxide (158) in the gate zone (150), the dummy gate oxide (158) being deposited between the acts of forming the STI (106) in the gate zone (150) and the source/drain zone (160) and forming the dummy gate (151) on the STI (106) in the gate zone (150).

11. The method according to any one of the preceding claims, wherein the act of removing the substrate (102) is performed by chemical-mechanical polishing, CMP.

12. The method according to any one of the preceding claims, wherein the act of forming the source/drain contact trench (166) further comprises:
from the backside (102b):
recessing the fin base (105) to form a fin base recess (103), wherein recessing the fin base (105) comprises selectively etching the fin base (105) by an etchant having a high etch rate on the fin base (105) and a low etch rate on the second and fourth dielectric materials (108b, 108d);
depositing a fifth dielectric material (108e) in the fin base recess (103), the fifth dielectric material (108e) being different from the second dielectric material (108b), the third dielectric material (108c), and the fourth dielectric material (108d).

13. The method according to claim 12, wherein the fifth dielectric material (108e) comprises at least one of: SiOC, SiOCN, SiOBCN, Si₃N₄, SiCN.

14. The method according to any one of the preceding claims, wherein the dummy gate (151) comprises amorphous silicon, a-Si.
